# EUROPEAN PATENT SPECIFICATION

(11) **EP 1 357 668 B1**
(45) Date of publication and mention of the grant of the patent: **03.10.2007**
(21) Application number: 02291025.1
(22) Date of filing: 23.04.2002
(51) Int. Cl.: H03M 1/12, G06K 9/00

(54) **Device and method for generating digital signals coding each a value of an analogue signal**
Gerät und Verfahren zur Erzeugung von digitalen Signalen, die jeweils einen analogen Signalwert kodieren
Dispositif et procédé pour la génération de signaux numériques chacun codant une valeur d'un signal analogique

(43) Date of publication of application: 29.10.2003
(73) Proprietor: STMicroelectronics S.A., 92120 Montrouge (FR); Idex ASA, 1385 Asker (NO)
(72) Inventor: Le Pailleur, Laurent, 38340 Voreppe (FR); Riisnaes, Knut Hovring, 1390 Vollen (NO); Vermesan, Ovidiu, 1369 Stabekk (NO)
(74) Representative: Loisel, Bertrand

(56) References cited:
- US-A- 3 852 714
- BLOKIN-MECHTALIN YU K ET AL: "MULTICHANNEL INSTRUMENTAL ANALOG-DIGITAL CONVERTER FOR BUS-MODULAR SYSTEMS" MEASUREMENT TECHNIQUES, CONSULTANTS BUREAU. NEW YORK, US, vol. 34, no. 11, 1 November 1991 (1991-11-01), pages 1100-1102, XP000307710 ISSN: 0543-1972

## Description

The present invention relates to the generating of digital signals coding each an amplitude value of a different analogue signal having a determined frequency.

Analogue signals come each from a sensor like a sensor electrode that gives a periodical wave tension value with an amplitude function of physical features or events to detect. Digital signals are useful to compute the values. It is known to use analogue digital converters for generating each a digital signal that codes values of an analogue signal.

With an analogue digital converter able to sample many points in a period of the analogue signal, some devices of the state of the art, determine the amplitude as resulting of a maximum of a curve comprising many digital points coding each an analogue point of the analogue signal. There are so many analogue digital converters as sensors. When the number of sensors is high, the resulting high number of analogue digital converters is cumbersome. Furthermore, a high-speed analogue digital converter is cumbersome per se and consumes a great quantity of energy. This cumbersome and consummation pose a problem for miniaturisation of electronic apparatuses, like organisers or mobile phones.

A possible solution is to use analogue digital converters of lower speed by valuating the amplitude at an analogue stage, for example with a filter or otherwise. This analogue valuation allows using of lower speed analogue digital converters converting only one value per period. Each analogue digital converter is therefore less cumbersome and less consuming. This solution is not satisfying for high miniaturisation because of still high cumbersome and consummation resulting of remaining high number of analogue digital converters. A problem also arises with many analogue digital converters because of necessary calibration to lessen a resolution loss when analogue digital converters are not rigorously identical.

An other solution is to use a reduced number of analogue digital converters by successively connecting one of a group of many sensors to a same analogue digital converter with help of an analogue multiplexer. However, it is difficult to reduce the number of analogue digital converters in a good proportion because here, a same sensor can be connected again to the analogue digital converter after a number of periods of analogue signal equal to the number or at the best to the half number of the sensors of the group. Indeed each valuation of the amplitude needs a total period, at the best a half period of the analogue signal received by an analogue digital converter. Lower is the quantity of analogue digital converters, higher is the time separating two samples of a same analogue signal. For example, connecting each sensor during a full period to a unique analogue digital converter, implies connecting again the same sensor after a number of periods, equal to the total number of sensors. A too long time between two digital conversions for a same analogue signal is not satisfying when amplitude values vary with a high rate in the time. A small number of sensors connectable to a same analogue digital converter, implies a still high number of analogue digital converters for all the sensors, still cumbersome and energy consuming.

Reference US 3,852,714 discloses an adaptive imaging system comprising as a sensing input a two-dimensional array of electro-optical detector elements coupled to a series of amplifier-filter circuits, each detector being coupled to a separate circuit. A sampling system comprises first and second sets of multiplexers coupled to the circuits so that the signals therefrom can be sampled in an addressably ordered manner. Each first multiplexer sequentially samples the signals from several circuits, and each second multiplexer sequentially samples the signals from several first multiplexers.

Reference US 5,166,685 discloses an analog-to-digital conversion system module which comprises a pin-limited A/D converter integrated circuit to which at least one multiplexer integrated circuit may be coupled and sampled.

Reference EP-A-0 110 794 discloses a data recording and storing system comprising a computing and control unit connected to a multiplexer having a plurality of analogue signal inputs, via sampling and analog/digital conversion means converting the analogue data into a sequence of samples separated from each other by a same predetermined time interval.

Reference JP-A-63238710 discloses an arithmetic processor providing A/D converting of plural input signals at periods corresponding to integer times the sampling period of a digital arithmetic processing part, arithmetically processing the converted signals and transferring the processed result to the arithmetic processing part every arithmetic period. Plural voltage/current informations inputted to an input part are inputted to a multiplexer, switched by time division and inputted to an A/D converter. The data A/D converted at the conversion period corresponding to integer times the arithmetic period of the arithmetic processing part are written in a memory. The A/D converted signals are arithmetically processed by a digital signal processor at the same period as the A/D conversion period and the arithmetic result data are transferred to the arithmetic part in each arithmetic period.

In view of the above listed prior art, an object of the invention is to provide a particularly compact device.

Such an arrangement allows to considerably reduce the number of analogue digital converters and therefore the size of the device.

Advantageously in the device, N is equal to the number of amplitude analogue values for which the analogue digital converter is suitable to generate digital signals coding each one of the amplitude analogue values during a period of said first analogue signal, in that each first new value is set for connecting the first multiple analogue output on a different first multiple analogue input during a period of said first analogue signal so as to connect the first multiple analogue output on all the first multiple analogue inputs during M periods of said first analogue signal and in that each second new value is set for connecting the fourth single analogue output on a different fourth single analogue input so as to connect the fourth single analogue output on all the fourth single analogue inputs during a period of said first analogue signal.

Here, one single analogue digital converter is sufficient to scan all the analogue signals.

Particularly, the device comprises a wave generator with at least one fifth analogue output for yielding a second analogue signal having a frequency and an amplitude, programmable in the front-end controller. The yielded analogue signal is a periodical signal like a sine wave or any other periodical signal with a repeated form suited for synchronisation.

More particularly for detecting or measuring, the device comprises at least one stimulation electrode tied to said fifth output and a number P of sensor electrodes tied each to one of the second single analogue inputs.

For special applications like command by finger, the stimulation electrode and the sensor electrodes are printed on a flexible band so as to constitute a finger print captor and the first and second multiplexers, the phase sensitive amplifier, the analogue digital converter, the front-end controller and the wave generator are encapsulated in an integrated circuit tied to said flexible band.

According to another aspect of the invention, there is further proposed a method according to claim 6.

The step of sampling and amplifying allows to sample and measure a complete subset of analogue signals In one time during a same period of analogue signal. The step of generating digital signals allows to sequentially digitalise the subset's measures during the same period. The iterations of these steps allow to digitalise a complete set of analogue signal measures with a short delay between two subsequent digitalisation of a same subset, increasing so the real time performance of digital measuring.

Advantageously to measure physical features not generating per se analogue signals, the method comprises a fourth step for continuously yielding a second analogue signal having a periodical form with programmable frequency and amplitude and for applying said second analogue signal to a body in such a way that a set of P different points of the body generate each, one of said first analogue signals with an amplitude value resulting of said programmable amplitude and of physical features of corresponding point of said body.

Particularly the first digital signals are computed to detect a movement of said body when the set of P different points change so as to change their physical features.

Particularly also, the first digital signals are computed to draw a map of points of the body along their changing to generate said first analogue signals.

Further embodiments, features and advantages of the present invention, as well as the structure and operation of the various embodiments of the present invention, are described in detail below with reference to the accompanying drawings wherein:
- figure 1 shows essential components and arrangement of a device according to the invention;
- figure 2 is a flow chart of a method according to the invention;
- figure 3 shows more details of a device according to the invention;
- figure 4 a special arrangement of sensors for the device.

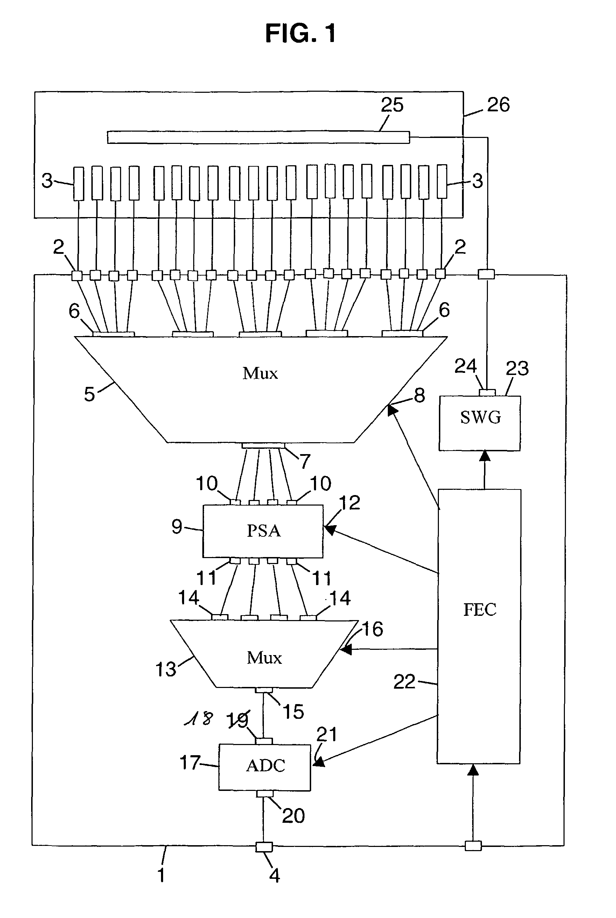

With reference to figure 1, one or many stimulation electrodes 25 and a plurality of sensor electrodes 3 are for example printed on a flexible sheet 26. Such an arrangement is useful for bio-impedance measurement systems by applying a periodical electrical tension signal with a determined frequency or frequencies on the one or many stimulation electrodes 25. When a body such as a human finger is both in contact with a stimulation electrode 25 and a sensor electrode 3, a biological electrical transfer function is reflected through an amplitude and or phase modulation of the original signal received as a first analogue signal on the sensor electrode 3. It is reminded that a fingerprint is constituted of ridges with mounts and valleys. With a stimulation electrode large enough to be in contact with a plurality of mounts and a sensor electrode small enough to be or not in contact with one mount, a different capacitive effect for a mount and a valley over the sensor electrode gives a different electrical transfer function between stimulation and sensor electrode, allowing therefore detection of a mount or a valley over the sensor electrode.

An integrated circuit 1 comprises a wave generator 23 with an output 24 to be connected with the one or many stimulation electrodes 25. The integrated circuit 1 comprises analogue inputs 2 for receiving each an analogue signal from a sensor electrode 3. When the wave generator 23 yields an analogue signal having a determined frequency F and a determined amplitude A, each analogue signal received by an input 2, has the same frequency F but with a phase and an amplitude A' which is a function of the capacitive effect between electrode 25 and corresponding electrode 3. A digital output 4 of the integrated circuit 1 is provided for sequentially generated a number P of digital signals coding each an amplitude value of one analogue signal. The P digital signals of the output 4 allow an other circuit not represented, like a microprocessor running a program, to recognise the mounts and valleys of a fingerprint in touch with the electrodes 3.

In the integrated circuit 1, a multiplexer 5 comprises a number M of multiple analogue inputs 6 connected each to a same number N of input 2. The multiplexer 5 comprises also a multiple analogue output 7 and a command input 8 for connecting the multiple analogue output 7 sequentially on one of the multiple analogue inputs 6. The numbers N and M are chosen so that their product is at least equal to P. A front-end controller 22 pilots the wave generator 23. For example, the front-end controller gives a clock signal and an amplitude reference to the wave generator 23. The wave generator is in that case, a filter adjusted to yield a sine wave signal, the frequency of which being the frequency of the clock signal and the amplitude value of which being the amplitude reference. The front-end controller 22 is designed for setting the command input 8 with a new value at each up-front of the clock signal which starts a period of the analogue signal yielded by the wave generator 23. The multiplexer 5 represented on figure 1 has a number M of five multiple analogue inputs. In that case, five different values are cycled applied to the command input 8.

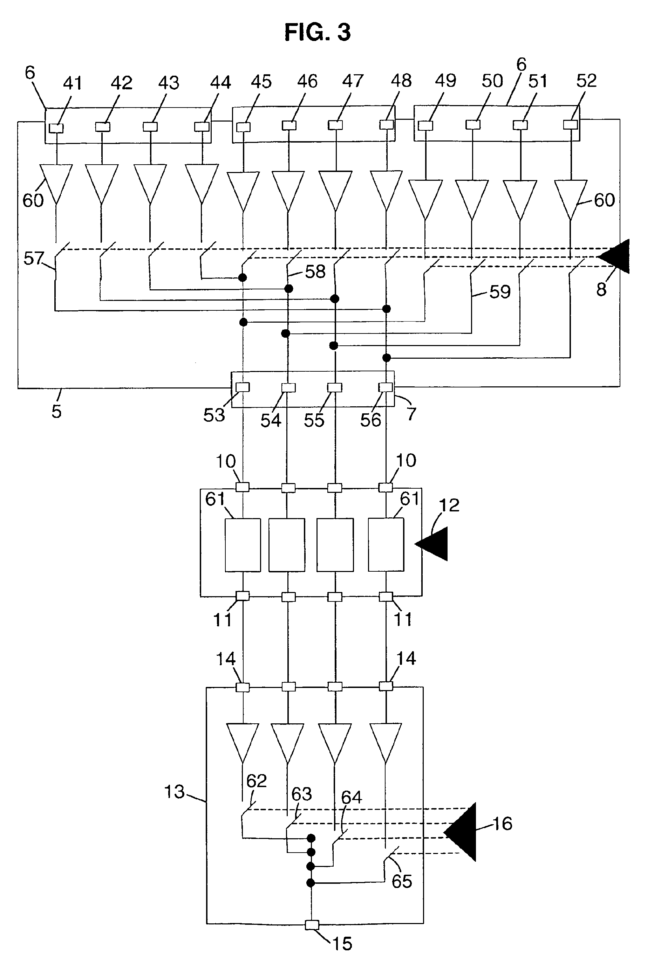

With reference to figure 3, the multiplexer 5 is represented more in details but with a number M of only three multiple analogue inputs 6 for sake of simplicity. Each multiple analogue input 6 has here a number N of four single analogue inputs 41 to 44, 45 to 48, 49 to 52. The multiple analogue output 7 has the same number N of four single analogue outputs 53 to 56. A four channels switch 57 is provided to connect the single analogue input 41 to the single analogue output 53, the single analogue input 42 to the single analogue output 54, the single analogue input 43 to the single analogue output 55, the single analogue input 44 to the single analogue output 56, when the command input 8 is set with a value therefore. A four channels switch 58 is provided to connect the single analogue input 45 to the single analogue output 53, the single analogue input 46 to the single analogue output 54, the single analogue input 47 to the single analogue output 55, the single analogue input 48 to the single analogue output 56, when the command input 8 is set with an other value therefore. A four channels switch 59 is provided to connect the single analogue input 49 to the single analogue output 53, the single analogue input 50 to the single analogue output 54, the single analogue input 51 to the single analogue output 55, the single analogue input 52 to the single analogue output 56, when the command input 8 is set with still an other value therefore.

In addition, the multiplexer 5 comprises an amplifier 60 on each channel between a single analogue input and a single analogue output.

In the integrated circuit 1, a phase sensitive amplifier 9 comprises a same number N of four single analogue inputs 10 tied each to a second single analogue output 53, 54, 55, 56 of the multiplexer 5, a same number N of four single analogue outputs 11 and a command input 12. Between each single analogue input 10 and each analogue single output 11, is connected for example an integrator 61 on the positive rectified of analogue signal. The integrator 61 is reset by a pulse value received on the command input 12. The front-end controller 22 being designed for setting the command input 12 with a pulse value at the beginning of each period of said first analogue signal, each integrator generates on each single analogue output 11 an amplitude analogue value of the analogue signal received on corresponding analogue input 10 during the second half of period of the analogue signal.

In the integrated circuit 1, a multiplexer 13 comprises the same number N of four single analogue inputs 14 tied each to a single analogue output 11 of the phase sensitive amplifier 9, a single analogue output 15 and a command input 16 for connecting the single analogue output 15 sequentially on one of the single analogue inputs 14. The multiplexer 13 comprises a one channel switch 62, 63, 64, 65 which connect one of the single analogue input 14 on the single analogue output 15 for a different value applied on the command input 16. The front-end controller 22 is designed for setting the command input 16 with a null value during first period of analogue signal yielded by wave generator 23 so as to open each switch 62, 63, 64, 65 during first period of the analogue signal. The front-end controller 22 is designed for setting the command input 16 with a succession of N new values during second period of analogue signal yielded by wave generator 23 so as to close successively each switch 62, 63, 64, 65 during second period of the analogue signal.

In the integrated circuit 1, an analogue digital converter 17 comprises a single analogue input 18 tied to the single analogue output 15 of the multiplexer 13, a single digital output 20 tied to the first output 4 of the integrated circuit 1 and a command input 21. The front-end controller 22 is designed for setting the command input 21 with a succession of N pulse values, each pulse value being generated during the time of which, a new value is applied on command input 16. In this way, the analogue digital converter 17 is able to generate a digital signal coding the amplitude analogue value received on the single analogue input 19 for each single analogue input 14 connected on the analogue output 15.

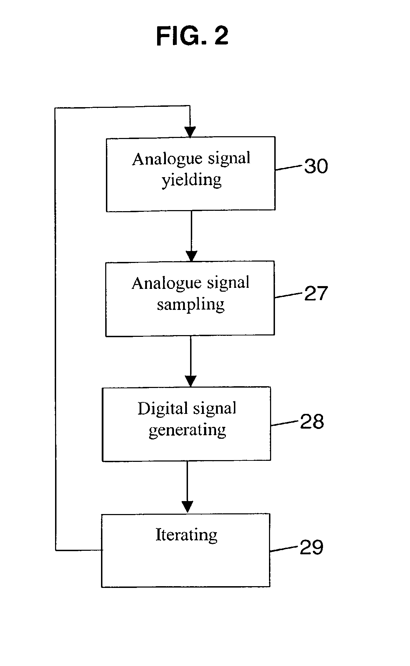

A method for generating a number P of digital signals coding each an amplitude value of one first analogue signal having a frequency F, is now described with reference to figure 2.

In a step 27, N analogue signals are sampled during a period of analogue signal. The amplitude value is measured at an analogue stage for all the sampled analogue signals in the same time.

In a step 28, each measured analogue signal is converted at a time for successively generating one of N digital signal coding each the amplitude analogue value of the N first sampled analogue signals, during a same period of one analogue signal.

A step 29 is provided for iterating a number M of times steps 27 and 28 for other different analogue signals in a manner to sample a complete number P of first analogue signals.

For measuring applications in electrical environments like in study of appliances electrical behaviour or natural phenomenon, the analogue signals can come from external sources like alternative currents on an energy line.

For measuring applications in other environments like in study of physical features of different points of a body, a step 30 is provided for continuously yielding an analogue signal having a periodical form with programmable frequency and amplitude and for applying this analogue signal to a body in such a way that a set of P different points of the body generate each, one of analogue signals to be measured, with an amplitude value resulting of said programmable amplitude and of physical features of corresponding point of said body. The advantage of programmable frequency is in the ability to adjust it in a manner to get a high variation of transfer function for different physical features.

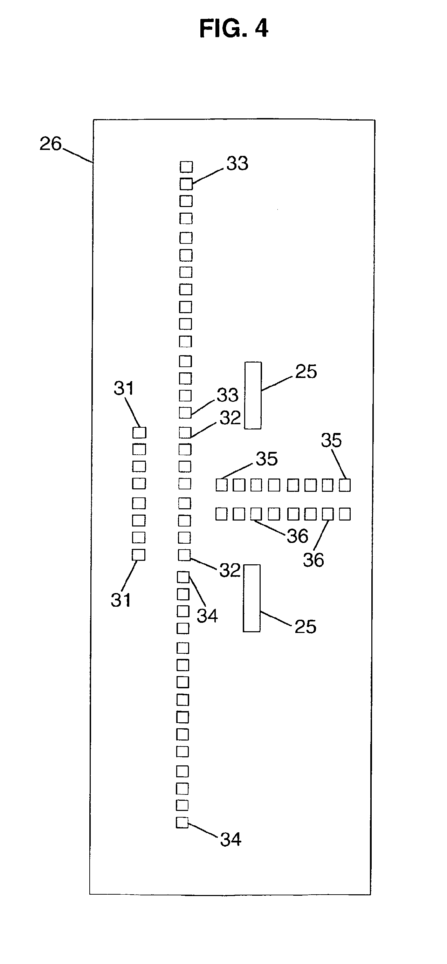

With reference to figure 4, the sensor electrodes 3, here particularly distinguished with references 31 to 36 and the stimulation electrode 25 are printed on a flexible sheet 26.

The flexibility of the sheet is particularly suited to resist on pressures applied by a physical body like a finger in contact with the sheet. We note on figure 4 that the width of the sheet 26 is of small proportion with regard to its length. The small width of the sheet is particularly suited for implementing it on the front face of a mobile phone where a screen and a keyboard already exist. The length value of the sheet 26 is sensibly equal to the overage width of a finger.

A first straight line with a great number of sensor electrodes 32, 33, 34, is printed on the surface along the length of the sheet 26. A square map of sensor electrodes to cover the surface of a fingerprint would be too cumbersome on the front face of a small appliance like a mobile phone or a personal organiser. A line is enough when associated with a movement of the body across the line.

A second smaller straight line with sensor electrodes 31, is printed at a predetermined small distance and in parallel with the first straight line.

The sensor electrodes and the stimulation electrodes shown on figure 4 are connected to the integrated circuit 1 in a similar manner as the one shown on figure 1. Contiguous sensor electrodes are not necessarily connected to a same multiple analogue input of multiplexer 5. The man skill in the art is free to choose a topology of connections that he estimates best suited to scan in real time physical features of a body like more particularly here a fingerprint. The integrated circuit 1 is mounted for example under the flexible sheet 26 in a manner to be protected against pressures of the body when contacting the sheet 26.

Considering the digital signals sequentially generated during a sampling period by output 4 for analogue signals originated from sensor electrodes 32, 33, 34, these signals give a said first horizontal transverse section of the fingerprint with a first pattern of mounts and valleys along this first section.

Considering the digital signals sequentially generated during the same sampling period by output 4 for analogue signals originated from sensor electrodes 31, these signals give a said second horizontal transverse section of another part of the fingerprint at a perpendicular distance equal to the predetermined distance between the two straight lines. This allows to observe a second pattern of mounts and valleys along this second section.

Processor running programme are provided to detect the second pattern in the first pattern during a following sampling period when a finger moves from smaller straight line to longer straight line. The oriented distance on the fingerprint between the first pattern for the following sampling period and the first pattern for the preceding sampling period, is equal to the known distance between the set of sensor electrodes 31 and the subset of sensor electrodes 32, 33, 34, corresponding to the detected second pattern. We note that the movement of the finger doesn't need to be necessarily rigorously perpendicular to the straight lines. When the finger moves a little bit to the right, the second pattern is detected for some right situated sensor electrodes 32 and for a complement of some left situated sensor electrodes 33. When the finger moves a little bit to the left, the second pattern is detected for some left situated sensor electrodes 32 and for a complement of some right situated sensor electrodes 34. When the finger moves more to the right, the second pattern is detected for some sensor electrodes 33. When the finger moves more to the left, the second pattern is detected for some sensor electrodes 34. The distance is computed with known trigonometric considerations, knowing the distances between electrodes.

An acceptable complete map of the fingerprint is got when the finger has finished to move across the first straight line.

We see that this disposition of sensor electrodes is suitable not only to scan a fingerprint but also to detect a displacement of a finger in a first crossing direction centred on perpendicular direction with an angle tolerance of more than 45 degrees on each side. Correlated to a clock generator, the displacement detection allows also to measure a speed of crossing by the finger.

A third straight line with sensor electrodes 35 is perpendicular to the first straight line. A fourth straight line with sensor electrodes 36 is parallel to the third straight line. The third and fourth straight lines are provided for detection displacement of the finger across them in a second crossing direction centred on perpendicular direction with an angle tolerance of more than 45 degrees on each side. The third and fourth straight lines don't need to be so long as respectively the first and second straight lines because they are not provided for fingerprint scanning but for displacement detection in a direction around the said horizontal direction.

A correlation of first and second crossing directions by computer means procures a direction with distance of displacement of the finger on the fingerprint captor constituted by the sheet 26. Such a procured displacement is useful for pointer and navigation functions on the screen of a mobile phone.

For example in the case where the number of sensor electrodes is greater or in the case where it is preferable to have slower analogue digital converters, the above previous described elements 5, 9, 13 can be duplicated in parallel for two or more groups of different sensor electrodes with a different analogue digital converter 17 for each output of multiplexer 13 associated with a group. When only one output 4 of circuit 1 is provided, a further multiplexer not represented, can be introduced with so many inputs as there are groups, each connected to one output 20 of analogue digital converter 17 for a group. An output of the further multiplexer is therefore connected the output 4 instead of connecting an output 20 of single digital analogue converter to the output 4.

## Claims

1. Device comprising a number P of first single analogue inputs (2) for receiving each a first analogue signal having a frequency F from a sensor electrode (3), and a first single digital output (4) for sequentially generating a number P of first digital signals coding each an amplitude value of one first analogue signal, **characterised in that** it comprises:
- a first multiplexer (5) with a number M of first multiple analogue inputs (6) comprising each a number N of second single analogue inputs for receiving each one said analogue signal, with a first multiple analogue output (7) comprising a number N of second single analogue outputs, and with a first command input (8) for connecting the first multiple analogue output sequentially on one of the first multiple analogue inputs, numbers N and M being chosen so that their product is at least equal to P;
- a phase sensitive amplifier (9) with a number N of third single analogue inputs (10) tied each to a second single analogue output of the first multiplexer, with a number N of third single analogue outputs (11), and with a second command input (12) for generating on each third single analogue output (11) an amplitude analogue value of an analogue signal received on corresponding third analogue input (10);
- a second multiplexer (13) with a number N of fourth single analogue inputs (14) tied each to a third single analogue output (11) of the phase sensitive amplifier (9), with a fourth single analogue output (15) and with a third command input (16) for connecting the fourth single analogue output (15) sequentially on one of the fourth single analogue inputs (14);
- an analogue digital converter (17) with a fifth single analogue input (18) tied to the fourth single analogue output (15) of the second multiplexer (13), with a second single digital output (20) tied to said first output (4) of the device (1), and with a fourth command input (21) for generating a digital signal coding the amplitude analogue value received on said fifth single analogue input (19);
- a front-end controller (22) designed for setting said first command input (8) with a first new value, and said second command input (12) with a first pulse value at the beginning of each period of said first analogue signal, and for setting said third command input (16) with a succession of N second new values, and said fourth command input (21) with a succession of N second pulse values at a time delayed after the beginning of each period of said first analogue signal.

2. Device according to claim 1 **characterised in that** N is equal to the number of amplitude analogue values for which the analogue digital converter (21) is suitable to generate digital signals coding each one of the amplitude analogue values during a period of said first analogue signal, **in that** each first new value is set for connecting the first multiple analogue output (7) on a different first multiple analogue input (6) during a period of said first analogue signal so as to connect the first multiple analogue output (7) on all the first multiple analogue inputs (6) during M periods of said first analogue signal and **in that** each second new value is set for connecting the fourth single analogue output (15) on a different fourth single analogue input (14) so as to connect the fourth single analogue output (15) on all the fourth single analogue inputs (14) during a period of said first analogue signal.

3. Device according to claim 1 or 2, **characterised in that** it comprises a wave generator (23) with at least one fifth analogue output (24) for yielding a second analogue signal having a frequency and an amplitude programmable in the front-end controller (22).

4. Device according to claim 3 **characterised in that** it comprises:
- at least one stimulation electrode (25) tied to said fifth output (24);
- a number P of sensor electrodes (3) tied each to one of the second single analogue inputs.

5. Device according to claim 4 **characterised in that**:
- the stimulation electrode (25) and the sensor electrodes (3) are printed on a flexible band (26) so as to constitute a finger print captor;
- the first and second multiplexers (5,13), the phase sensitive amplifier (9), the analogue digital converter (17), the front-end controller (22) and the wave generator (23) are encapsulated in an integrated circuit (1) tied to said flexible band.

6. Method for generating a number P of first digital signals each coding an amplitude value of a respective one of first analogue signals having the same frequency F,
**characterised in that** it comprises:
- sampling (27) a number N of first analogue signals (6), each of said first analogue signals (6) measuring an amplitude analogue value, and amplifying said first sampled analogue signals, during one period of one of said first analogue signals ;
- successively generating (28) N digital signals each coding the amplitude analogue value of a respective one of the N first sampled and amplified analogue signals, during a same period of one of said first analogue signals;
- iterating (29) a number M of times the sampling and amplifying step and the generating step for M different sets of N first analogue signals each, in a manner so as to sample a complete number P of first analogue signals, where numbers N and M are chosen so that their product is at least equal to P.

7. Method according to claim 6, **characterised in that** it comprises a fourth step (30) for continuously yielding a second analogue signal having a periodical form with programmable frequency and amplitude and for applying said second analogue signal to a body in such a way that a set of P different points of the body generate each, one of said first analogue signals with an amplitude value resulting of said programmable amplitude and of physical features of corresponding point of said body.

8. Method according to claim 7 **characterised in that** first digital signals are computed to detect a movement of said body when the set of P different points change so as to change their physical features.

9. Method according to claim 8 **characterised in that** first digital signals are computed to draw a map of points of the body along their changing to generate said first analogue signals.

## Patentansprüche

1. Vorrichtung, die eine Anzahl P von ersten Einzelanalogeingaben (2), um jeweils ein erstes Analogsignal mit einer Frequenz F von einer Sensorelektrode (3) zu empfangen, und eine erste Einzeldigitalausgabe (4) aufweist, um sequentiell eine Anzahl P von ersten Digitalsignalen zu erzeugen, die jeweils einen Amplitudenwert des einen ersten Analogsignals kodieren, **dadurch gekennzeichnet, dass** sie aufweist:
- einen ersten Multiplexer (5) mit einer Anzahl M von ersten Mehrfachanalogeingaben (6), die jeweils eine Anzahl N von zweiten Einzelanalogeingaben aufweisen, um jedes einzelne Analogsignal zu empfangen, mit einer ersten Mehrfachanalogausgabe (7), die eine Anzahl N von zweiten Einzelanalogausgaben aufweist, und mit einer ersten Befehlseingabe (8), um die erste Mehrfachanalogausgabe sequentiell mit einer der ersten Mehrfachanalogeingaben zu verbinden, wobei die Anzahlen N und M so gewählt sind, dass ihr Produkt mindestens gleich P ist;
- einen phasensensitiven Verstärker (9) mit einer Anzahl N von dritten Einzelanalogeingaben (10), die jeweils mit einer zweiten Einzelanalogausgabe des ersten Multiplexers verknüpft sind, mit einer Anzahl N von dritten Einzelanalogausgaben (11) und mit einer zweiten Befehlseingabe (12), um für jede dritte Einzelanalogausgabe (11) einen Amplitudenanalogwert eines Analogsignals zu erzeugen, das auf der entsprechenden dritten Analogeingabe (10) empfangen wurde;
- einen zweiten Multiplexer (13) mit einer Anzahl N von vierten Einzelanalogeingaben (14), die jeweils mit einer dritten Einzelanalogausgabe (11) des phasensensitiven Verstärkers (9) verknüpft sind, mit einer vierten Einzelanalogausgabe (15) und mit einer dritten Befehlseingabe (16), um die vierte Einzelanalogausgabe (15) sequentiell mit einer der vierten Einzelanalogeingaben (14) zu verbinden;
- einen Analog-Digital-Umsetzer (17) mit einer fünften Einzelanalogeingabe (18), die mit der vierten Einzelanalogausgabe (15) des zweiten Multiplexers (13) verknüpft ist, mit einer zweiten Einzeldigitalausgabe (20), die mit der ersten Ausgabe (4) der Vorrichtung (1) verknüpft ist, und mit einer vierten Befehlseingabe (21), um ein Digitalsignal zu erzeugen, das den auf der fünften Einzelanalogeingabe (19) empfangenen Amplitudenanalogwert kodiert;
- einen Front-End-Controller (22), der vorgesehen ist, um am Anfang jeder Periode des ersten Analogsignals die erste Befehlseingabe (8) auf einen ersten neuen Wert und die zweite Befehlseingabe (12) auf einen ersten Pulswert zu setzen, und um zu einer Zeit, die gegenüber dem Beginn jeder Periode des ersten Analogsignals verzögert ist, die dritte Befehlseingabe (16) auf eine Folge von N zweiten neuen Werten zu setzen und die vierte Befehlseingabe (21) auf eine Folge von N zweiten Pulswerten zu setzen.

2. Vorrichtung nach Anspruch 1, **dadurch gekennzeichnet, dass** N gleich der Anzahl der Amplitudenanalogwerte ist, für die der Analog-Digital-Umsetzer (21) geeignet ist, um Digitalsignale zu erzeugen, die jeden der Amplitudenanalogwerte während einer Periode des ersten Analogsignals kodieren, indem jeder erste neue Wert gesetzt wird, um die erste Mehrfachanalogausgabe (7) während einer Periode des ersten Analogsignals mit einer anderen ersten Mehrfachanalogeingabe (6) zu verbinden, um so die erste Mehrfachanalogausgabe (7) während M Perioden des ersten Analogsignals mit allen ersten Mehrfachanalogeingaben (6) zu verbinden, und indem jeder zweite neue Wert gesetzt wird, um die vierte Einzelanalogausgabe (15) mit einer anderen vierten Einzelanalogeingabe (14) zu verbinden, um so die vierte Einzelanalogausgabe (15) während einer Periode des ersten Analogsignals mit allen vierten Einzelanalogeingaben (14) zu verbinden.

3. Vorrichtung nach Anspruch 1 oder 2, **dadurch gekennzeichnet, dass** sie einen Wellengenerator (23) mit mindestens einer fünften Analogausgabe (24) aufweist, um ein zweites Analogsignal mit einer Frequenz und einer Amplitude zu ergeben, die in dem Front-End-Controller (22) programmierbar sind.

4. Vorrichtung nach Anspruch 3, **dadurch gekennzeichnet, dass** sie aufweist:
- mindestens eine Stimulationselektrode (25), die mit der fünften Ausgabe (24) verknüpft ist;
- eine Anzahl P Sensorelektroden (3), die jeweils mit einer der zweiten Einzelanalogeingaben verknüpft sind.

5. Vorrichtung nach Anspruch 4, **dadurch gekennzeichnet, dass**
- die Stimulationselektrode (25) und die Sensorelektroden (3) auf ein flexibles Band (26) gedruckt sind, um so einen Fingerabdruckerfasser zu bilden;
- die ersten und zweiten Multiplexer (5,13), der phasensensitive Verstärker (9), der Analog-Digital-Umsetzer (17), der Front-End-Controller (22) und der Wellengenerator (23) in einem integrierten Schaltkreis (1) verkapselt sind, der mit dem flexiblen Band verknüpft ist.

6. Verfahren zum Erzeugen einer Anzahl P von ersten Digitalsignalen, die jeweils einen Amplitudenwert eines jeweiligen ersten Analogsignals mit der gleichen Frequenz F kodieren, **dadurch gekennzeichnet, dass** es aufweist:
- Abtasten (27) einer Anzahl N von ersten Analogsignalen (6), wobei jedes der ersten Analogsignale (6) einen Amplitudenanalogwert misst, und Verstärken der ersten abgetasteten Analogsignale während einer Periode von einem der ersten Analogsignale;
- aufeinanderfolgendes Erzeugen (28) von N Digitalsignalen, die während einer gleichen Periode von einem der ersten Analogsignale jeweils den Amplitudenanalogwert von jeweils einem der N ersten abgetasteten und verstärkten Analogsignale kodieren;
- M-maliges iteratives Wiederholen (29) der Abtast-und Verstärkungsschritte und des Erzeugungsschritts für M unterschiedliche Sätze von jeweils N ersten Analogsignalen, um so eine vollständige Anzahl P von ersten Analogsignalen abzutasten, wobei die Anzahlen N und M so gewählt werden, dass ihr Produkt mindestens gleich P ist.

7. Verfahren nach Anspruch 6, **dadurch gekennzeichnet, dass** es einen vierten Schritt (30) aufweist, um kontinuierlich ein zweites Analogsignal mit einer periodischen Form mit programmierbarer Frequenz und Amplitude zu ergeben, und um das zweite Analogsignal in einer solchen Weise auf einen Körper anzuwenden, dass ein Satz von P unterschiedlichen Punkten des Körpers jedes einzelne der ersten Analogsignale mit einem Amplitudenwert erzeugt, der aus der programmierbaren Amplitude und den physikalischen Merkmalen des entsprechenden Punkts des Körpers resultiert.

8. Verfahren nach Anspruch 7, **dadurch gekennzeichnet, dass** die ersten Digitalsignale berechnet werden, um eine Bewegung des Körpers zu detektieren, wenn der Satz von P unterschiedlichen Punkten sich ändert, so dass sich ihre physikalischen Merkmale verändern.

9. Verfahren nach Anspruch 8, **dadurch gekennzeichnet, dass** erste Digitalsignale berechnet werden, um eine Karte aus Punkten des Körpers auf dem Weg ihrer Veränderung zu zeichnen, um die ersten analogen Signale zu erzeugen.

## Revendications

1. Dispositif comprenant un nombre P de premières entrées analogiques uniques (2) destinées à recevoir chacune, d'une électrode de détection (3), un premier signal analogique ayant une fréquence F, et une première sortie numérique unique (4) destinée à générer séquentiellement un nombre P de premiers signaux numériques codant chacun une valeur d'amplitude d'un premier signal analogique, **caractérisé en ce qu'**il comprend :
- un premier multiplexeur (5) avec un nombre M de premières entrées analogiques multiples (6) comportant chacune un nombre N de secondes entrées analogiques uniques destinées à recevoir chacune un dit signal analogique, avec une première sortie analogique multiple (7) comportant un nombre N de deuxièmes sorties analogiques uniques, et avec une première entrée (8) d'instructions destinée à connecter successivement la première sortie analogique multiple à une des premières entrées analogiques multiples, les nombres N et M étant choisis de façon que leur produit soit au moins égal à P;
- un amplificateur (9) sensible à la phase avec un nombre N de troisièmes entrées analogiques uniques (10) liées chacune à une deuxième sortie analogique unique du premier multiplexeur, avec un nombre N de troisièmes sorties analogiques uniques (11), et avec une deuxième entrée (12) d'instructions servant à générer sur chaque troisième sortie analogique unique (11) une valeur analogique d'amplitude d'un signal analogique reçu sur la troisième entrée analogique correspondante (10) ;
- un deuxième multiplexeur (13) avec un nombre N de quatrièmes entrées analogiques uniques (14) liées chacune à une troisième sortie analogique (11) de l'amplificateur (9) sensible à la phase, avec une quatrième sortie analogique unique (15) et avec une troisième entrée (16) d'instructions servant à connecter séquentiellement la quatrième sortie analogique unique (15) sur une des quatrièmes entrées analogiques uniques (14) ;
- un convertisseur analogique/numérique (17) avec une cinquième entrée analogique unique (18) liée à la quatrième sortie analogique unique (15) du deuxième multiplexeur (13), avec une deuxième sortie numérique unique (20) liée à ladite première sortie (4) du dispositif (1), et avec une quatrième entrée (21) d'instructions servant à générer un signal numérique codant la valeur analogique d'amplitude reçue sur ladite cinquième entrée analogique unique (19) ;
- un contrôleur frontal (22) conçu pour fixer une première nouvelle valeur pour ladite première entrée (8) d'instructions, et pour fixer une première valeur d'impulsion pour ladite deuxième entrée (12) d'instructions au début de chaque période dudit premier signal analogique, et pour fixer une succession de N deuxièmes nouvelles valeurs pour ladite troisième entrée (16) d'instructions, et pour fixer une succession de N deuxièmes valeurs d'impulsions pour ladite quatrième entrée (21) d'instructions à un instant retardé après le début de chaque période dudit premier signal analogique.

2. Dispositif selon la revendication 1, **caractérisé en ce que** N est égal au nombre de valeurs analogiques d'amplitude pour lesquelles le convertisseur analogique/numérique (21) convient pour produire des signaux numériques codant chacun une des valeurs analogiques d'amplitude pendant une période dudit premier signal analogique, **en ce que** chaque première nouvelle valeur est fixée pour connecter la première sortie analogique multiple (7) sur une première entrée analogique multiple différente (6) pendant une période dudit premier signal analogique de manière à connecter la première sortie analogique multiple (7) sur toutes les premières entrées analogiques multiples (6) pendant M périodes dudit premier signal analogique et **en ce que** chaque deuxième nouvelle valeur est fixée pour connecter la quatrième sortie analogique unique (15) sur une quatrième entrée analogique unique différente (14) afin de connecter la quatrième sortie analogique unique (15) sur la totalité des quatrièmes entrées analogiques uniques (14) pendant une période dudit premier signal analogique.

3. Dispositif selon la revendication 1 ou 2, **caractérisé en ce qu'**il comprend un générateur (23) d'ondes avec au moins une cinquième sortie analogique (24) pour produire un deuxième signal analogique ayant une fréquence et une amplitude programmables dans le contrôleur frontal (22).

4. Dispositif selon la revendication 3, **caractérisé en ce qu'**il comprend :
- au moins une électrode de stimulation (25) liée à ladite cinquième sortie (24) ;
- un nombre P d'électrodes de détection liées chacune à une des deuxièmes entrées analogiques uniques.

5. Dispositif selon la revendication 4, **caractérisé en ce que** :
- l'électrode de stimulation (25) et les électrodes de détection (3) sont imprimées sur une bande souple (26) de façon à constituer un capteur d'empreinte digitale ;
- les premier et deuxième multiplexeurs (5, 13), l'amplificateur (9) sensible à la phase, le convertisseur analogique/numérique (17), le contrôleur frontal (22) et le générateur (23) d'ondes sont réalisés dans un circuit intégré (1) lié à ladite bande souple.

6. Procédé pour générer un nombre P de premiers signaux numériques codant chacun une valeur d'amplitude d'un signal, respectif, parmi des premiers signaux analogiques ayant la même fréquence F, **caractérisé en ce qu'**il comprend des étapes consistant à :
- échantillonner (27) un nombre N de premiers signaux analogiques (6), chacun desdits premiers signaux analogiques (6) mesurant une valeur analogique d'amplitude et amplifier lesdits premiers signaux analogiques échantillonnés, pendant une période d'un desdits premiers signaux analogiques ;
- générer successivement (28) N signaux numériques codant chacun la valeur analogique d'amplitude d'un signal, respectif, parmi les N premiers signaux analogiques échantillonnés et amplifiés, pendant une même période d'un desdits premiers signaux analogiques ;
- itérer (29) un nombre M de fois l'étape d'échantillonnage et d'amplification et l'étape de génération pour M différents ensembles de N premiers signaux analogiques chacun, de manière à échantillonner un nombre complet P de premiers signaux analogiques, les nombres N et M étant choisis de façon que leur produit soit au moins égal à P.

7. Procédé selon la revendication 6, **caractérisé en ce qu'**il comprend une quatrième étape (30) pour produire en continu un deuxième signal analogique ayant une forme périodique à fréquence et amplitude programmables et pour appliquer ledit deuxième signal analogique à un corps de façon qu'un ensemble de P points différents du corps génèrent chacun un desdits premiers signaux analogiques avec une valeur d'amplitude résultant de ladite amplitude programmable et de caractères physiques du point correspondant dudit corps.

8. Procédé selon la revendication 7, **caractérisé en ce que** lesdits premiers signaux numériques sont calculés pour détecter un mouvement dudit corps lorsque l'ensemble de P points différents changent de façon à changer leurs caractéristiques physiques.

9. Procédé selon la revendication 8, **caractérisé en ce que** des premiers signaux numériques sont calculés pour tracer une carte de points du corps à mesure qu'ils changent afin de générer lesdits premiers signaux analogiques.
